# FASCICULE DE BREVET EUROPEEN

(11) **EP 1 721 337 B1**
(45) Date de publication et mention de la délivrance du brevet: **19.09.2007**
(21) Numéro de dépôt: 05716754.6
(22) Date de dépôt: 21.02.2005
(51) Int. Cl.: H01L 29/768

(54) **CIRCUIT INTEGRE AVEC DIODE DE LECTURE DE TRES PETITES DIMENSIONS**
INTEGRIERTE SCHALTUNG MIT EINER SEHR KLEINEN LESEDIODE
INTEGRATED CIRCUIT WITH A VERY SMALL-SIZED READING DIODE

(30) Priorité: 02.03.2004 FR 0402148
(43) Date de publication de la demande: 15.11.2006
(73) Titulaire: E2V SEMICONDUCTORS, 38120 Saint Egreve (FR)
(72) Inventeur: BLANCHARD, Pierre, THALES, F-94117 Arcueil (FR)
(74) Mandataire: Guérin, Michel
(86) Numéro de dépôt international: PCT/EP2005/050740
(87) Numéro de publication internationale: WO 2005/096388

(56) Documents cités:
- US-A- 5 192 990
- PATENT ABSTRACTS OF JAPAN vol. 018, no. 499 (E-1607), 19 septembre 1994 (1994-09-19) -& JP 06 168964 A (TOSHIBA CORP), 14 juin 1994 (1994-06-14)

## Description

L'invention concerne les circuits intégrés comportant à la fois des grilles conductrices déposées au-dessus d'un substrat semiconducteur et des diodes formées dans ce substrat.

L'application principale envisagée est un registre de lecture de charges électriques, fonctionnant par transfert de charges dans le substrat semiconducteur sous l'influence de potentiels variables appliqués à des grilles juxtaposées au-dessus du substrat et isolées du substrat. De tels registres sont présents dans les capteurs d'image matriciels réalisés en technologie CCD (de l'anglais Charge Coupled Devices). Ils servent notamment à récupérer, ligne par ligne, les charges stockées dans une matrice d'éléments photosensibles pour les envoyer vers un circuit de lecture qui les convertit en tensions ou courants électriques représentant le niveau de charges photogénérées en chaque point de la ligne.

Le registre de lecture constitué par des grilles ou électrodes juxtaposées se termine en général par une diode formée dans le substrat, diode qui permet d'effectuer la conversion d'une quantité de charges en niveau de tension électrique. Le document US 5 192 990 décrit un circuit intégré comportant un registre de transfert des charges avec une diode de lecture au bout du registre, dans lequel la connexion électrique de la diode au reste du circuit est faite par un contact au-dessus de la diode. La diode de lecture doit être aussi petite que possible pour réduire au maximum sa capacité ; en effet si la capacité de la diode est trop grande, elle empêche un fonctionnement du registre à des vitesses très élevées.

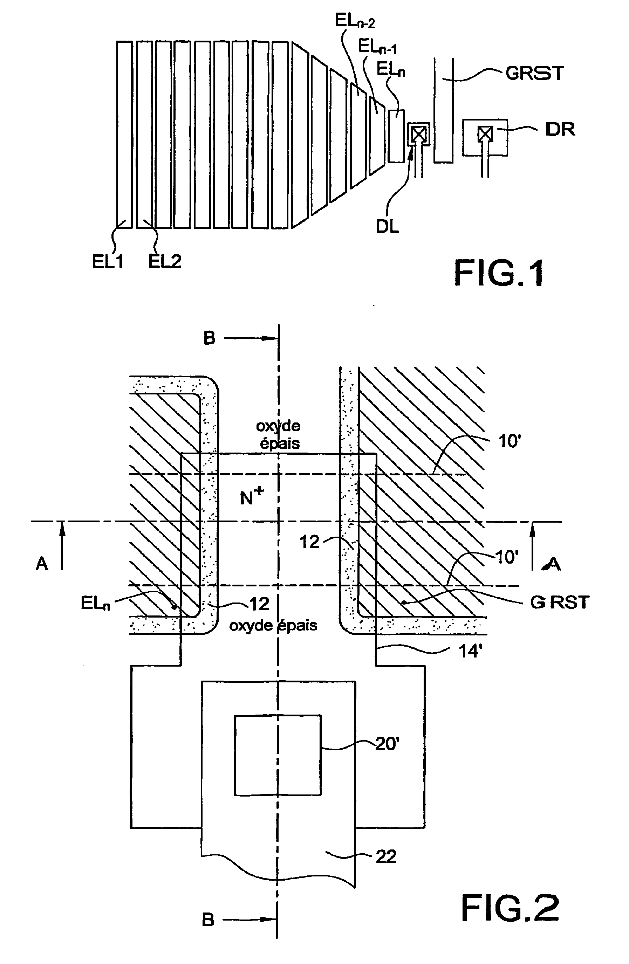

C'est pourquoi la configuration du registre de lecture est en **général celle qui est représentée à la figure 1 : les grilles ou électrodes EL1,** EL2, etc. du registre, d'abord régulièrement et identiquement disposées le long du registre, se terminent en un entonnoir qui concentre les charges vers une petite diode de lecture DL.

La technologie utilisée pour réaliser la diode limite cependant vers les valeurs inférieures la taille qu'on peut donner à la diode ; en effet, la diode est enserrée entre la dernière électrode ELn du registre et une autre électrode ou grille de silicium GRST ; l'électrode GRST ou grille de remise à niveau constitue une barrière entre la diode et une région de silicium dopée formant drain DR, cette barrière servant à rétablir périodiquement le potentiel de la diode à un niveau constant avant une nouvelle lecture de charges. D'autre part, la diode doit être reliée au reste du circuit de lecture (non représenté) par au moins une connexion électrique, et la prise de contact de cette connexion sur la diode occupe une place non négligeable qui oblige à utiliser une diode plus grande que celle qui est vraiment nécessaire pour le fonctionnement du circuit.

C'est pourquoi la présente invention propose un procédé de fabrication d'une diode de petites dimensions entre deux électrodes de silicium déposées au-dessus d'un substrat, ce procédé comportant les étapes suivantes :
- a) réalisation sur le substrat des deux électrodes séparées par un intervalle,
- b) oxydation thermique d'une partie de l'épaisseur des électrodes, en hauteur et en largeur, en laissant subsister un espace entre les électrodes oxydées, le substrat étant protégé contre l'oxydation dans cet espace ;
- c) mise à nu de la surface du substrat dans cet espace,
- d) dépôt d'une couche de silicium polycristallin dopé venant en contact dans cet espace avec le substrat pour former un pôle de la diode, le substrat formant l'autre pôle,
- e) élimination partielle du silicium polycristallin en laissant subsister un motif désiré, ce motif recouvrant au moins l'espace laissé entre les électrodes et recouvrant également une région située hors de cet espace ;
- f) dépôt d'une couche isolante, gravure locale d'une ouverture dans cette couche isolante au-dessus du silicium polycristallin hors de l'espace situé entre les électrodes, pour former une zone de contact déportée, dépôt d'une couche conductrice venant en contact avec le silicium polycristallin dans la zone de contact déportée, et gravure de la couche métallique selon un motif d'interconnexions désiré.

La zone de contact est déportée par rapport à la zone constituant la diode en ce sens que la couche conductrice, de préférence un métal et de préférence de l'aluminium, vient en contact avec la couche de silicium polycristallin en un endroit qui n'est pas situé au-dessus de la diode.

De préférence, pour l'étape e) d'élimination partielle du silicium polycristallin, on procède de la manière suivante : on dépose sur le silicium polycristallin une couche uniforme de nitrure de silicium, on la grave selon un motif qui laisse subsister la couche au-dessus des zones de silicium polycristallin qu'on veut conserver, et on oxyde le silicium sur toute son épaisseur là où il n'est pas recouvert de nitrure, jusqu'à obtenir un motif de silicium qui ne comprend que les zones qui ont été recouvertes de nitrure. On notera qu'en variante on peut prévoir, entre le dépôt de la couche de nitrure et l'étape ultérieure d'oxydation du silicium polycristallin, d'attaquer chimiquement le silicium polycristallin pour l'enlever autant que possible là où il n'est pas protégé par le nitrure, avant de procéder à l'oxydation.

Dans le cas de l'utilisation de nitrure de silicium, l'ouverture locale de la couche isolante à l'étape f) comprend aussi l'ouverture du nitrure de silicium pour mettre à nu le silicium polycristallin dans la zone de contact avant dépôt de la couche conductrice.

Typiquement, avec ce procédé, on peut réaliser une diode de dimensions environ 1,5 micromètre par 1,5 micromètre alors qu'un procédé plus classique, consistant à ouvrir une zone de contact dans une couche isolante directement au-dessus de la diode et à déposer de l'aluminium au-dessus de cette zone pour venir en contact avec le substrat, ne permettrait pas de descendre au-dessous de 4 micromètre par 4 micromètre, compte-tenu des marges qu'il faut prendre lors de l'ouverture de la zone de contact.

L'invention propose, à titre d'application, un circuit intégré comportant un registre de transfert de charges avec une diode de lecture au bout du registre, entre une dernière électrode du registre et une électrode de remise à niveau, caractérisé en ce que la diode de lecture est constituée par une région dopée délimitée d'un côté par les électrodes et de l'autre côté par des régions d'oxyde de silicium épais, la région dopée étant entièrement recouverte d'une couche de silicium polycristallin délimitée selon un motif qui s'étend en partie au-dessus de l'oxyde épais, la couche de silicium étant recouverte d'une couche isolante comportant une ouverture au-dessus de l'oxyde épais mais pas d'ouverture au-dessus de la région dopée, et la couche isolante étant elle-même recouverte d'une couche conductrice venant en contact avec le silicium polycristallin à travers l'ouverture.

D'autres caractéristiques et avantages de l'invention apparaîtront à la lecture de la description détaillée qui suit et qui est faite en référence aux dessins annexés dans lesquels :
- la figure 1 déjà décrite représente la constitution schématique d'un registre de lecture à transfert de charges ;
- la figure 2 représente, en vue de dessus et en détail la diode de lecture réalisée ;
- les figures 3 et 4 représentent en coupe, respectivement selon la ligne A-A et selon la ligne B-B de la figure 2, la diode de lecture ;
- les figures 5 à 11 représentent les différentes étapes de réalisation de la diode ; sur chaque figure, la partie de gauche représente le substrat coupé selon la ligne A-A de la figure 2, c'est-à-dire une ligne coupant les deux électrodes qui encadrent la diode, tandis que la partie droite représente le substrat coupé selon la ligne B-B de la figure 2, c'est-à-dire une ligne qui passe entre les électrodes sans les couper.

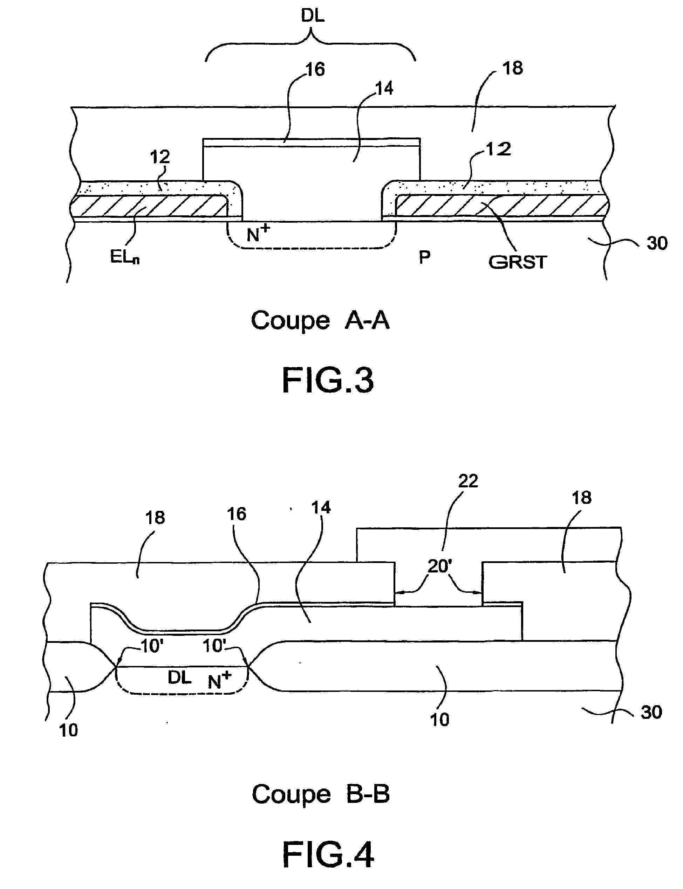

Sur la figure 2 (vue de dessus) et sur les figures 3 et 4 (coupes selon AA et selon B respectivement), la diode de lecture DL est définie par une zone dopée de type N+ diffusée dans le substrat 30 de type P. La zone dopée constitue un pôle de la diode, le substrat un autre pôle.

Dans le sens latéral des figures 2 et 3 (à gauche et à droite sur la figure 2 et sur la figure 3), cette zone est délimitée en pratique par les bords des deux grilles ou électrodes ELn et GRST qui l'encadrent. Les électrodes sont hachurées sur les figures 2 et 3. Dans le sens vertical de la feuille de la figure 2 (en haut et en bas sur la figure 2, à gauche et à droite sur la figure 4), la zone diffusée de type N+ est délimitée par des régions d'oxyde épais 10 (oxyde thermique classique LOCOS). Les lignes tiretées 10' de la figure 2 représentent les bords des zones d'oxyde épais 10 encadrant la diode. La zone correspondant à la diode DL ne comporte pas d'oxyde épais.

Les grilles ELn et GRST sont en silicium polycristallin et elles sont recouvertes d'une couche isolante d'oxyde de silicium 12 représentée en pointillés sur les figures 2 et 3.

Une couche de silicium polycristallin conducteur 14, dopée de type N+ et gravée selon un motif approprié, vient en contact avec toute la zone de substrat 30 au-dessus de la diode DL là où le substrat n'est pas protégé par les grilles ELn et GRST et l'oxyde de silicium 10- Cette couche de silicium remonte sur l'oxyde épais 10 comme on le voit sur la figure 4. Le motif de silicium polycristallin est délimité par une ligne 14' sur la figure 2. Ce motif permet de réaliser un contact électrique entre le pôle N+ de la diode et une couche conductrice d'aluminium, ce contact étant déporté c'est-à-dire non situé au-dessus de la diode mais situé au-dessus de l'oxyde épais 10.

Le motif de silicium polycristallin 14 est de préférence recouvert d'une couche de nitrure de silicium 16. L'ensemble du motif de silicium polycristallin 14 et de la couche de nitrure 16 est recouvert d'une couche isolante de passivation 18 qui recouvre aussi d'autres parties de la structure. Ces deux couches 16 et 18 sont localement ouvertes à l'endroit du contact désiré avec une couche d'aluminium, donc à un endroit situé au-dessus de l'oxyde épais 10, mais pas au-dessus de la zone constituant la diode DL. L'ouverture de contact ainsi définie est délimitée par la ligne 20' de la figure 2. La couche métallique 22 est de préférence une couche d'aluminium, gravée selon un motif d'interconnexions désiré, déposée au-dessus de la couche isolante 18 et venant en contact avec le silicium polycristallin 14 à travers l'ouverture formée dans les couches d'oxyde 18 et de nitrure 16 au-dessus de l'oxyde épais 10. On notera que la couche de nitrure de silicium est délimitée par le même motif (ligne 14') que la couche de silicium polycristallin sur laquelle elle est déposée, à l'exception des zones où elle est ouverte pour permettre un contact électrique entre la couche de silicium polycristallin et la couche conductrice 22.

Sur les figures 2 à 4 on n'a pas représenté le drain DR classiquement prévu (cf. figure 1) de l'autre côté de la grille GRST. Ce drain sera fait comme la diode de lecture DL comme on l'expliquera plus loin.

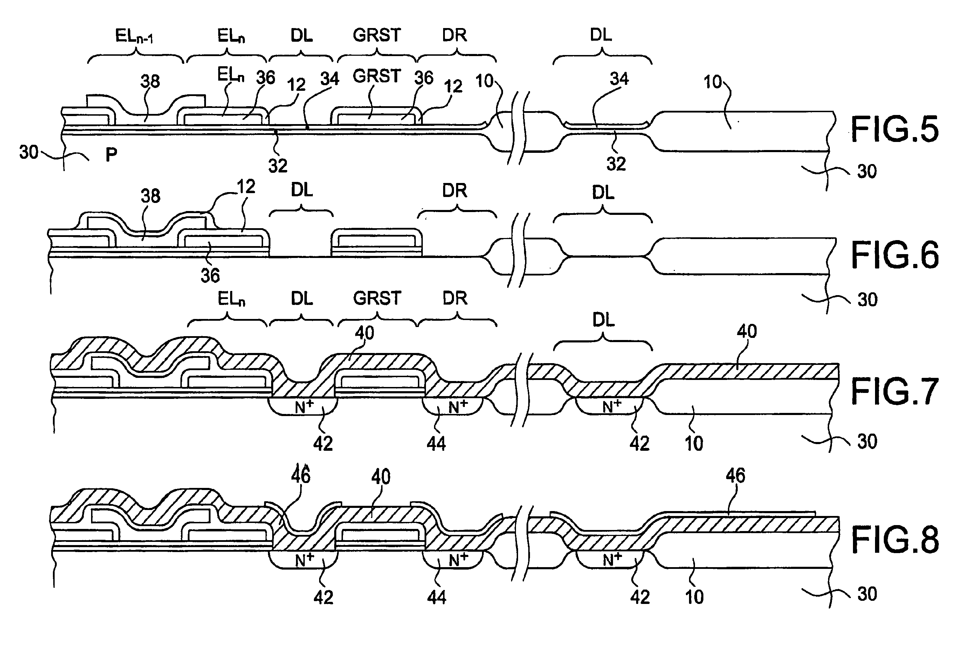

Les figures 5 et suivantes représentent les différentes étapes de fabrication selon l'invention.

On part d'un substrat de silicium 30 de type P présentant éventuellement des variations de profil de dopage nécessaires au fonctionnement (notamment une couche superficielle mince de transfert en volume, de type N, non représentée) et on forme des grilles de silicium polycristallin adjacentes permettant la constitution d'électrodes d'un registre à transfert de charges, ceci selon un procédé classique qui peut être typiquement le suivant :
- oxydation superficielle du substrat produisant une couche d'oxyde mince uniforme 32 ;
- dépôt d'une couche mince uniforme de nitrure de silicium 34 ;
- gravure du nitrure selon un motif correspondant aux zones d'isolation désirées en oxyde épais 10 ;
- oxydation thermique épaisse de type LOCOS pour former les zones 10 là où il n'y a plus de nitrure ;
- dépôt d'une première couche uniforme de si licium polycristallin 36 ;
- gravure de cette couche 36 pour définir une première série d'électrodes de rang pair n, n-2, n-4, n-6, etc., espacées les unes des autres, parmi lesquelles l'électrode ELn et aussi l'électrode GRST ; les électrodes de rang impair n-1, n-3, n-5, viendront ultérieurement s'intercaler entre les électrodes de rang pair ;
- oxydation thermique de la couche 36 pour que le silicium de cette couche se recouvre latéralement et superficiellement d'oxyde de silicium isolant 12 ;
- dépôt uniforme d'une deuxième couche de silicium polycristallin 38 qui vient notamment remplir l'espace entre les électrodes formées dans la première couche (par exemple entre l'électrode ELn de rang n et l'électrode de rang n-2 qui la précède dans la première série) ;
- gravure de la deuxième couche 38 pour définir une deuxième série d'électrodes, de rang impair ; les deux séries d'électrodes juxtaposées forment un registre permettant un transfert de charges dans le substrat par application de potentiels variables aux électrodes ; le silicium polycristallin de la deuxième couche 38 est entièrement enlevé dans l'espace entre les grilles ELn et GRST, espace réservé à la diode de lecture DL, ainsi que dans l'espace qui sera réservé à la formation d'un drain DR.

La figure 5 représente le circuit intégré à ce stade de la fabrication.

Les étapes suivantes, plus spécifiques à l'invention vont maintenant être décrites.

On oxyde superficiellement par un procédé d'oxydation thermique la surface supérieure de l'ensemble. Le silicium polycristallin de la deuxième couche 38 se recouvre superficiellement et latéralement d'u ne couche d'oxyde isolant de la même manière que le silicium polycristallin de la couche 36 avait été recouvert d'une couche d'oxyde 12. Au cours de la même opération d'oxydation, l'épaisseur de la couche 12 s'accroît. Etant donné que les couches d'oxyde formées lors de ces deux opérations d'oxydation sont de même nature, on a désigné sur la figure 6 par une seule référence 12 la couche d'oxyde qui recouvre toutes les électrodes à la fin de cette deuxième opération d'oxydation du silicium polycristallin.

A la suite de cette opération d'oxydation, on enlève la couche de nitrure 34 là où elle n'est pas protégée par les électrodes, c'est-à-dire dans les zones DL et DR réservées à la diode de lecture et au drain de remise à niveau. On enlève également la couche d'oxyde de silicium très mince 32 qui est mise à nu par l'enlèvement du nitrure. Ces deux dernières opérations n'affectent pratiquement pas la couche 12 qui est beaucoup plus épaisse que la couche 32.

La figure 6 représente le circuit intégré à la fin de cette étape.

On dépose alors une troisième couche uniforme 40 de silicium polycristallin qui vient remplir notamment l'espace entre les électrodes ELn et GRST ainsi que l'espace réservé au drain DR et qui vient directement en contact avec le substrat 30 dénudé dans ces espaces. Cette couche 40 formera ultérieurement le motif d'interconnexion 14 en silicium polycristallin des figures 2 à 4.

On dope fortement avec une impureté de type N le silicium de la couche 40, soit pendant le dépôt (dépôt en présence d'arsenic) soit après le dépôt et on procède à un traitement thermique suffisamment intense et prolongé pour que les impuretés de type N se diffusent dans le su bstrat là où le silicium polycristallin est en contact avec le substrat dénudé (régions DL et DR). On forme ainsi une région diffusée 42 de type N+ dans le substrat qui constitue un premier pôle de la diode de lecture DL, le substrat constituant un deuxième pôle ; et on forme en même temps une région diffusée 44 de type N+ qui constitue le drain DR. Il est à noter que le traitement thermique peut se répartir au cours d'étapes ultérieures de la fabrication (notamment au cours des opérations d'oxydation), mais pour simplifier les explications on considère qu'il est fait dès ce moment.

La figure 7 représente le circuit à ce stade.

On effectue alors une succession d'opérations destinées à délimiter des zones de silicium polycristallin de la couche 40 pour former des motifs d'interconnexion désirés avec cette couche. Pour ce qu i concerne plus spécifiquement la diode de lecture, le motif d'interconnexion est le motif délimité par la ligne 14' de la figure 2, c'est-à-dire un motif qui permet de déporter le contact d'aluminium (qu'on établira ultérieurement) ailleurs qu'au-dessus de la diode de lecture. Un autre motif peut être établi pour la connexion de la région de drain DR, et d'autres motifs encore sur le reste du circuit intégré.

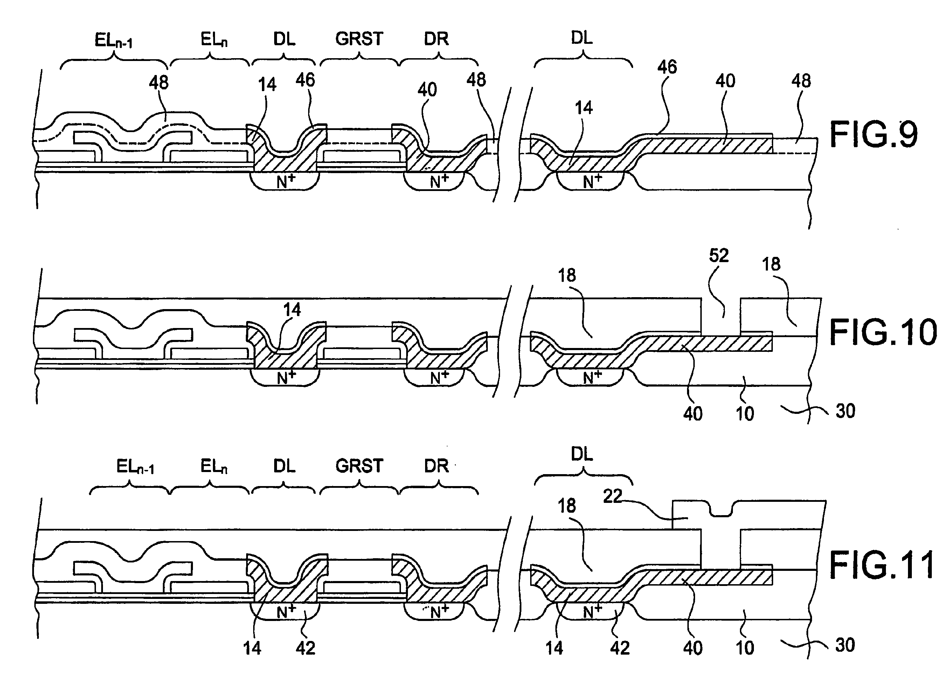

On pourrait procéder à une gravure du silicium poly cristallin par attaque chimique de la couche 40 à travers une résine de masquage photogravée, mais une simple gravure du silicium présente des risques de défauts gênants ; en effet, lorsque le relief de la surface est accentué, la gravure peut laisser dans les transitions brusques de relief des résidus de silicium qui sont cause de court-circuits. On préfère procéder d'une autre manière :
a) on dépose sur la couche uniforme 40 une couche de nitrure de silicium 46 et on grave cette couche selon un motif qui laisse subsister uniquement les zones d'interconnexion désirées. La figure 8 représente le circuit à ce stade. On voit qu'on a gardé une zone de nitrure 46 qui d'une part recouvre la région de la diode de lecture 42 et qui d'autre part se prolonge au-dessus de l'oxyde épais 10.
b) on effectue alors un traitement thermique d'oxydation profonde du silicium polycristallin de la troisième couche 40. Cette oxydation se produit dans la masse du silicium là où il n'est pas protégé par le nitrure 46. Le silicium polycristallin est entièrement transformé en oxyde de silicium 48 là où il n'est pas protégé. On aboutit à la structure de la figure 9, avec un motif d'interconnexions en silicium polycristallin 40 recouvert de nitrure, et, en dehors de ce motif, une couche d'oxyde de silicium 48 protégeant toutes les électrodes du registre.

On notera qu'on aurait pu, après dépôt et gravure du nitrure, également graver la couche de silicium polycristallin 40 par attaque chimique à travers le même masque qui a servi à graver la couche de nitrure 46, et procéder ensuite seulement à l'étape b, à savoir l'oxydation thermique des résidus qui ont pu subsister après cette gravure du silicium.

Après avoir ainsi défini les motifs d'interconnexion de la couche 40, aboutissant à un motif d'interconnexion 14 défini à propos des figures 2 à 4, on dépose alors une couche de protection isolante 18, qui peut servir aussi de couche de planarisation (couche d'oxyde ou de polyimide notamment). On pratique dans cette couche, ainsi que dans la couche de nitrure sous-jacente 46, une ouverture locale 50 à un endroit où on désire un contact avec le motif d'interconnexion en silicium polycristallin 40. L'ouverture 50 qui sert à établir le contact électrique avec la région N+ 42 de la diode de lecture est située au-dessus de l'oxyde épais 10 comme on le voit sur la figure 10 ; son contour correspond au contour 20' de la figure 2.

On dépose enfin (figure 11) une couche conductrice 22, de préférence une couche d'aluminium, et on grave cette couche selon les motifs d'interconnexion désirés. La couche 22 remplit l'ouverture 50 et vient en contact avec le silicium polycristallin donc vient en contact indirectement avec la région N+ de la diode de lecture DL.

La dimension de la diode DL peut être seulement de 1,5 micromètre par 1,5 micromètre, ce qui ne serait pas possible si le contact d'aluminium venait au-dessus de la diode (la dimension minimale serait plutôt de 4,5 par 4,5 micromètres).

## Revendications

1. Procédé de fabrication d'une diode (DL) de petites dimensions entre deux électrodes de silicium (ELn, GRST) déposées au-dessus d'un substrat (30), qui comporte les étapes suivantes :
- a) réalisation au-dessus du substrat des deux électrodes séparées par un intervalle,
- b) oxydation thermique d'une partie de l'épaisseur des électrodes, en hauteur et en largeur, en laissant subsister un espace entre les électrodes oxydées, le substrat étant protégé contre l'oxydation dans cet espace ;
- c) mise à nu de la surface du substrat dans cet espace,
- d) dépôt d'une couche de silicium polycristallin dopé (40) venant en contact dans cet espace avec le substrat pour former un pôle (42) de la diode, le substrat formant l'autre pôle,
- e) élimination partielle du silicium polycristallin en laissant subsister un motif désiré, ce motif recouvrant au moins l'espace laissé entre les électrodes et recouvrant également une région située hors de cet espace
- f) dépôt d'une couche isolante (18), gravure locale d'une ouverture (50) dans cette couche isolante au-dessus du silicium polycristallin hors de l'espace situé entre les électrodes, pour former une zone de contact déportée, dépôt d'une couche métallique (22) venant en contact avec le silicium polycristallin dans la zone de contact déportée, et gravure de la couche métallique selon un motif d'interconnexions désiré.

2. Procédé selon la revendication 1, **caractérisé en ce que** pour l'étape e) d'élimination partielle du silicium polycristallin, on dépose une couche uniforme de nitrure de silicium (46), on la grave selon un motif qui laisse subsister la couche au-dessus des zones de silicium polγcristallin qu'on veut conserver, et ultérieurement on oxyde le silicium sur toute son épaisseur là où il n'est pas recouvert de nitrure, jusqu'à obtenir un motif de silicium qui ne comprend que les zones qui ont été recouvertes de ni-trure.

3. Procédé selon la revendication 2, **caractérisé en ce que** entre le dépôt de la couche de nitrure et l'étape ultérieure d'oxydati on du silicium polycristallin, on attaque chimiquement le silicium polycristallin pour l'enlever autant que possible là où il n'est pas protégé par le nitrure.

4. Circuit intégré comportant un registre de transfert de charges avec une diode de lecture au bout du registre, entre une dernière électrode du registre et une électrode de remise à niveau, **caractérisé en ce que** la diode de lecture est constituée par une région dopée (42) délimitée d'un côté par les électrodes et de l'autre côté par des régions d'oxyde de silicium épais (10), la région dopée étant entièrement recouverte d'une couche de silicium polycristallin (14, 40) délimitée selon un motif qui s'étend en partie au-dessus de l'oxyde épais, la couche de silicium étant recouverte d'une couche isolante (18) comportant une ouverture (50) au-dessus de l'oxyde épais mais pas d'ouverture au-dessus de la région dopée, et la couche isolante étant elle-même recouverte d'une couche conductrice venant en contact avec le silicium polycristallin à travers l'ouverture (50).

5. Circuit intégré selon la revendication 4, **caractérisé en ce que** la couche de silicium polycristallin est recouverte de nitrure de silicium elle-même recouverte par la couche isolante (50), la couche de nitrure étant également ouverte à l'endroit de l'ouverture dans la couche isolante.

## Claims

1. Method for fabricating a diode (DL) of small dimensions between two silicon electrodes (ELn, GRST) deposited above a substrate (30), which comprises the following steps:
- a) producing the two electrodes, separated by a gap, above the substrate,
- b) thermally oxidizing a part of the thickness of the electrodes, in height and in width, leaving a space remaining between the oxidized electrodes, the substrate being protected against oxidation in this space;
- c) exposing the surface of the substrate in this space,
- d) depositing a layer of doped polycrystalline silicon (40) entering into contact with the substrate in this space in order to form one pole (42) of the diode, the substrate forming the other pole,
- e) partially removing the polycrystalline silicon while leaving a desired pattern remaining, this pattern covering at least the space left between the electrodes and also covering a region lying outside this space,
- f) depositing an insulating layer (18), locally etching an opening (50) into this insulating layer above the polycrystalline silicon outside the space lying between the electrodes, in order to form an offset contact zone, depositing a metal layer (22) entering into contact with the polycrystalline silicon in the offset contact zone, and etching the metal layer according to a desired pattern of interconnections.

2. Method according to Claim 1, **characterized in that** for step e) of partially removing the polycrystalline silicon, a uniform layer of silicon nitride (46) is deposited, this is etched according to a pattern which leaves the layer remaining above the polycrystalline silicon zones that are intended to be kept, and the silicon is subsequently oxidized over its entire thickness wherever it is not covered with nitride, until a silicon pattern is obtained which comprises only the zones that were not covered with nitride.

3. Method according to Claim 2, **characterized in that** between the deposition of the nitride layer and the subsequent step of oxidizing the polycrystalline silicon, the polycrystalline silicon is chemically etched in order to remove it as much as possible wherever it is not protected by the nitride.

4. Integrated circuit comprising a CCD register with a readout diode at the end of the register, between the last electrode of the register and a reset electrode, **characterized in that** the readout diode consists of a doped region (42) delimited on one side by the electrodes and on the other side by regions of thick silicon oxide (10), the doped region being entirely covered with a layer of polycrystalline silicon (14, 40) delimited according to a pattern which extends partly above the thick oxide, the silicon layer being covered with an insulating layer (18) comprising an opening (50) above the thick oxide but no opening above the doped region, and the insulating layer being itself covered with a conductive layer entering into contact with the polycrystalline silicon through the opening (50).

5. Integrated circuit according to Claim 4, **characterized in that** the polycrystalline silicon layer is covered with silicon nitride, itself covered by the insulating layer (50), the nitride layer also being open at the position of the opening in the insulating layer.

## Patentansprüche

1. Verfahren zur Herstellung einer sehr kleinen Diode (DL) zwischen zwei Siliziumelektroden (ELn, GRST), die oberhalb eines Substrats (30) deponiert sind, das folgende Schritte aufweist:
a) Realisieren der zwei Elektroden, die durch einen Abstand getrennt sind, oberhalb des Substrats,
b) thermisches Oxidieren eines Anteils der Dicke der Elektroden in der Höhe und in der Breite, indem ein Zwischenraum zwischen den oxidierten Elektroden fortbesteht, wobei das Substrat in diesem Zwischenraum vor Oxidation geschützt ist,
c) Freilegen der Fläche des Substrats in diesem Zwischenraum,
d) Deponieren einer Schicht dotierten polykristallinen Siliziums (40), die in diesem Zwischenraum mit dem Substrat in Kontakt tritt, um einen Pol (42) der Diode zu bilden, wobei das Substrat den anderen Pol bildet,
e) teilweises Entfernen des polykristallinen Siliziums, indem ein gewünschtes Muster fortbesteht, wobei dieses Muster mindestens den zwischen den Elektroden gelassenen Zwischenraum abdeckt und ferner einen außerhalb dieses Zwischenraums befindlichen Bereich abdeckt
f) Deponieren einer Isolierschicht (18), lokales Ätzen einer Öffnung (50) in diese Isolierschicht oberhalb des polykristallinen Siliziums außerhalb des zwischen den Elektroden befindlichen Zwischenraums, um eine versetzte Kontaktzone zu bilden, Deponieren einer Metallschicht (22), die in Kontakt mit dem polykristallinen Silizium in der versetzten Kontaktzone tritt, und Ätzen der Metallschicht nach einem gewünschten Interconnect-Muster.

2. Verfahren nach Anspruch 1, **dadurch gekennzeichnet, dass** man beim Schritt e) des teilweisen Entfernens des polykristallinen Siliziums eine gleichmäßige Schicht Siliziumnitrid (46) deponiert, sie nach einem Muster ätzt, das die Schicht oberhalb der Zonen aus polykristallinem Silizium, die erhalten werden sollen, fortbestehen lässt, und dass man anschließend das Silizium über seine gesamte Dicke da oxidiert, wo es nicht mit Nitrid abgedeckt ist, bis ein Muster aus Silizium erhalten wird, das nur die Zonen, die mit Nitrid abgedeckt wurden, umfasst.

3. Verfahren nach Anspruch 2, **dadurch gekennzeichnet, dass** man zwischen dem Deponieren der Nitridschicht und dem anschließenden Schritt der Oxidation des polykristallinen Siliziums das polykristalline Silizium chemisch angreift, um es weitmöglichst da, wo es nicht durch das Nitrid geschützt ist, zu entfernen.

4. Integrierte Schaltung, umfassend ein Ladungsübertragungsregister mit einer Lesediode am Ende des Registers zwischen einer letzten Elektrode des Registers und einer Ausgleichselektrode, **dadurch gekennzeichnet, dass** die Lesediode durch einen dotierten Bereich (42) gebildet wird, der auf der einen Seite durch die Elektroden und auf der anderen Seite durch Bereiche aus dickem Siliziumoxid (10) abgegrenzt ist, wobei der dotierte Bereich gänzlich mit einer Schicht aus polykristallinem Silizium (14, 40) abgedeckt ist, die entsprechend eines Musters, das sich teilweise oberhalb des dicken Oxids erstreckt, begrenzt ist, wobei die Siliziumschicht mit einer Isolierschicht (18) abgedeckt ist, die eine Öffnung (50) oberhalb des dicken Oxids, aber keine Öffnung oberhalb des dotierten Bereichs aufweist, und wobei die Isolierschicht selber mit einer leitfähigen Schicht abgedeckt ist, die durch die Öffnung (50) in Kontakt mit dem polykristallinen Silizium tritt.

5. Integrierte Schaltung nach Anspruch 4, **dadurch gekennzeichnet, dass** die Schicht aus polykristallinem Silizium selber durch die Isolierschicht (50) mit Siliziumnitrid abgedeckt ist, wobei die Nitridschicht auch an der Stelle der Öffnung in die Isolierschicht geöffnet ist.
